# EUROPEAN PATENT APPLICATION

(11) **EP 1 091 414 A2**
(43) Date of publication of application: **11.04.2001**
(21) Application number: 00308378.9
(22) Date of filing: 25.09.2000
(51) Int. Cl.: H01L 29/423, H01L 21/336, H01L 21/28

(54) **MOSFET with tapered gate and method of manufacturing it**

(30) Priority: 07.10.1999 US 414226
(71) Applicant: LUCENT TECHNOLOGIES INC., Murray Hill, New Jersey 07974-0636 (US)
(72) Inventor: Chang, Chorng-Ping, Berkeley Heights, New Jersey 07922 (US); Pai, Chien-Shing, Bridgewater, New Jersey 08807 (US); Vuong, Thi-Hong-Ha, Berkeley Heights, New Jersey 07922 (US)
(74) Representative: Buckley, Christopher Simon Thirsk

(57) **Abstract**

A semiconductor device, and a process for fabricating the device, is disclosed. The semiconductor device is an MOS device in which the gate (140,141,145) is bounded by spacers (135), which are in turn bounded by a trench in a trench dielectric layer (130) formed on a semiconductor substrate (100). The device is formed by lithographically defining a sacrificial gate on the surface of the semiconductor substrate. The trench dielectric layer (130) is then formed on the semiconductor substrate and adjacent to the sacrificial gate. The trench dielectric layer is planarized and, subsequent to planarization, the sacrificial gate is no longer covered by the trench dielectric layer. The sacrificial gate is then removed, which leaves a trench in the trench dielectric layer. Dielectric spacers (135) are then formed in the trench. The distance between the spacers defines the gate length of the semiconductor device. After the spacers are formed, the device gate (140,141,145) is formed. At least a portion of the gate is formed in the trench.

## Description

### BACKGROUND OF THE INVENTION

### Technical Field

The present invention is directed to a semiconductor device having a tapered gate stack configuration, and a process for fabricating such a device.

### Art Background

In the field of integrated circuits, the trend is to make devices, such as transistors, with smaller dimensions in order to fit more devices on a single chip. In addition to being able to fit more individual devices on a single chip, the smaller devices consume less power. This dual objective of fabricating smaller individual devices that consume less power presents certain challenges.

Specifically, when fabricating devices such as metal-oxide-semiconductor (MOS) transistors that have a gate length smaller than about 50 nm, it is contemplated that gate dielectric material and gate stack materials that are different from conventional materials used to fabricate larger MOS devices will have to be used. There are certain requirements that these materials must meet. First, the gate dielectric and gate stack materials must tolerate the temperatures to which they are exposed during subsequent processing. The dielectric constant of the gate dielectric material must be such that the tunneling current through the gate dielectric material is maintained at acceptable levels. The gate stack materials must provide suitably low gate resistance with decreasing gate dimensions.

Some alternative materials have been identified. For example, tantalum pentoxide has been identified as an alternative to silicon dioxide for the gate dielectric material. However, tantalum pentoxide cannot withstand the thermal budget necessary to activate the source and drain dopants that are introduced into the substrate by ion implantation.

Metals such as tungsten, aluminum and copper have been identified as candidate gate stack materials with a suitable low resistance. However, the temperatures that are required to activate the dopants that are implanted into the substrate after gate stack formation also limit the use of metals in the gate stack.

In order to avoid exposing metal gate stack materials to high temperature anneals for dopant activation, Chatterjee, A., et al., "CMOS Metal Replacement Gate Transistors using Tantalum Pentoxide Gate Insulator," IEDM 98, pp. 777-780 (1998) suggests that a sacrificial gate be used to define the source and drain areas during the implantation. This sacrificial gate is able to withstand the high temperatures used for the source/drain anneal. The sacrificial gate is then removed and replaced by a metal gate.

However, the process solution described in Chatterjee et al. does not solve all of the problems associated with fabricating devices having gate lengths of 50 nm or less. Specifically, current optical lithographic techniques are not suitable for defining features that are 50 nm or less. Also, the process solution described in Chattejee et al. does not solve the problem of junction scaling. This problem is described in Taur, Y., "25 nm CMOS Design Considerations," IEDM 98, pp. 789-792 (1998). Taur illustrates that an abrupt change in dopant type is required between the source/drain regions and the channel region for the short channel effects of the device to be within acceptable limits. Taur identifies an abrupt profile as one that is about 4-5 nm/decade for a 25 nm device. This abruptness in the lateral junction for NMOS devices was achieved by implanting boron to have a 2-D nonuniform (super-halo) dopant profile in the channel. However, this abrupt dopant profile is difficult to maintain because the dopants diffuse at the temperatures required to activate the dopants. This dopant diffusion leads to a non-abrupt junction in both the vertical and lateral dimension. Consequently, processes for fabricating MOS device structures having a gate length that is less than 50 nm, and processes for fabricating these devices, continue to be sought.

### SUMMARY OF THE INVENTION

The present invention is directed to a MOS device in which the device gate is bounded by spacers that define the gate length of the device. Both the device gate and the gate spacers are bounded by a trench. The present invention is also directed to a process for making the device. The device, and its method of fabrication, is advantageous for devices that have a gate length that is 50 nm or less because the gate length is not defined lithographically. However, the inventive device and process is not limited to devices with gate lengths of 50 nm or less, and includes devices (and processes for making those devices) with any gate length. In lithography, the feature size (e.g. gate length) is limited by the wavelength of the exposing radiation. The present devices are fabricated using a process in which the trench width is defined lithographically. Since the trench width is the combined gate length and spacer width, the lithographic requirements are relaxed compared to a process in which the gate length is defined lithographically. Consequently, optical lithographic techniques that are not suitable for defining features less than 70 nm are useful for fabricating the devices of the present invention. The spacers are advantageous because, with the spacers in place before the dopants are implanted in the channel, the gate length and the channel implant are precisely aligned. The spacers are also advantageous because, due to the masking effect of the spacers during the channel implant, the dopant profile in the substrate is suitably abrupt in the direction of the channel length. As previously noted for a 25 nm CMOS device, a suitably abrupt profile is about 4 to 5 nm/decade (or less). One skilled in the art will appreciate that the value for a suitably abrupt profile will change with the device scale.

In certain embodiments of the present invention, the channel implant is performed after either the trench or the spacers are formed. In these embodiments, the implant is referred to as a local channel implant. This is because the channel dopants are implanted only in the region of the substrate defined by either the trench or the trench/spacers (which is the channel region). Thus, a local channel implant is distinguished from the more conventional channel implant, in which channel dopants are implanted into the source/drain region in addition to the channel region.

In the process of the present invention, a sacrificial gate is first formed on a semiconductor substrate in which shallow trench isolation has been performed. Shallow trench isolation is a process well known to one skilled in the art and not described in detail herein. Shallow trench isolation is used to electrically isolate active regions on the device from other active regions.

The sacrificial gate is formed by depositing a layer of the sacrificial gate material on the substrate. Since the sacrificial gate material does not become part of the device, the material is selected for its suitability as a sacrificial gate material. In this regard, the sacrificial gate material is selected for its ability to be selectively removed with respect to the dielectric material (e.g. silicon dioxide) adjacent to the sacrificial gate material (for convenience this is referred to as the trench dielectric layer to distinguish it from the gate dielectric). The material is also selected to be compatible with the device fabrication sequence. Polycrystalline silicon, amorphous silicon and silicon nitride are contemplated as suitable sacrificial gate materials. Doped silicon dioxide (e.g. boron/phosphorous-doped silicon dioxide formed by depositing the doped oxide from BPTEOS) is also contemplated as a suitable sacrificial gate material. The layer of sacrificial gate material is then patterned using conventional lithographic techniques to define the sacrificial gate. The sacrificial gate is then used to define the source and drain regions of the device. The dopants are implanted in the semiconductor substrate with the sacrificial gate thereon to form the source and drain regions in the substrate. The substrate is subsequently annealed to activate the dopants.

A trench layer of dielectric material (e.g. silicon dioxide) is deposited over and adjacent to the sacrificial gate. The trench dielectric material is further processed so that the sacrificial gate is bounded by, but not covered by, the dielectric material. The sacrificial gate is then selectively removed, leaving a trench in the dielectric material layer. For convenience, this layer of dielectric material is referred to as the trench layer.

A second layer of dielectric material is blanket deposited over the structure with the trench layer of dielectric material. The thickness of the second layer of dielectric material is selected so that the trench in the underlying dielectric layer is not completely filled by the second dielectric material. Since the spacers are formed from this second layer of dielectric material, the second layer is referred to as the spacer layer. The spacer layer material is different from the trench layer material. The different materials are selected so that the trench layer material acts as an etch stop for the spacer etch. For example, in the embodiment wherein the trench layer of dielectric material is silicon dioxide, the spacer layer of material is silicon nitride (Si₃N₄).

The spacer layer is then anisotropically etched to form the spacers. Anisotropic etch expedients and conditions for etching dielectric materials are well known to one skilled in the art and are not discussed in detail herein. As a result of the anisotropic etch, only portions of the dielectric spacer material on the sidewalls of the trench remain. These remaining portions (referred to herein as spacers) taper inward toward the middle of the trench. The distance between the two spacers defines the device gate length. This is why the process of the present invention relaxes the lithographic requirements for defining the device gate length. Only the larger, sacrificial gate is defined lithographically. The device gate length is defined by the distance between the spacers formed in the trench that is, in turn, defined by the sacrificial gate.

After the spacers are formed, dopants are implanted into the substrate. This is referred to as a local channel implant. The implant energy is selected so that the dopants only penetrate into the substrate region between the spacers. Consequently, the region of the substrate doped by this implant is aligned with the space defined by the spacers formed in the trench. After the implant, an annealing step is used to activate the dopants.

The gate is then fabricated in the trench with the spacers therein. First, at least two layers of material are formed or deposited on the structure by blanket deposition. First a layer of dielectric material is formed. The layer of dielectric material becomes the gate dielectric layer. A layer of metal is formed over the gate dielectric layer. The particular metal that is selected is largely a matter of design choice, and depends upon the specific device being formed (e.g. NMOS or PMOS) and the particular gate dielectric material. For example, for a device with a supply voltage greater than about 1.5 volts, titanium nitride (TiN) is a suitable metal because it has a work function that is midway in the silicon bandgap (making TiN a suitable metal for both NMOS and PMOS devices when the supply voltage exceeds about 1.5 volts). However, as one skilled in the art is aware, as the supply voltage approaches the threshold voltage, metals with a work function closer to one of the valence band or the conduction band of silicon will be used. Such metals are suited for either NMOS devices or PMOS devices, but not both.

In an alternate embodiment, a layer of amorphous silicon is formed over the layer of dielectric material before the layer of metal is formed thereover. The layer of amorphous silicon, if present, is then doped using an ultra low energy implant followed by an anneal to make it suitably conductive. Gate formation is completed by removing the portions of these layers that do not overly the trench defined by the removal of the sacrificial gate.

It is advantageous if the trench dielectric layer deposited adjacent to the sacrificial gate is planarized before the sacrificial gate is removed. In the embodiment of the present invention wherein the sacrificial gate is silicon nitride, the trench dielectric layer is planarized using chemical mechanical polishing. The silicon nitride sacrificial gate stops the chemical mechanical polishing step.

The sacrificial gate is removed using a wet chemistry such as phosphorus acid at 180°C. This etchant selectively etches the silicon nitride sacrificial gate without significantly removing the first level dielectric material (e.g. the silicon dioxide).

It is advantageous if the gate electrode material formed over the gate dielectric is doped, amorphous silicon. Devices that have metal gate materials in contact with the gate dielectric have higher interface states at the metal/gate dielectric interface (compared with devices that have a doped polycrystalline silicon/gate dielectric interface). Higher interface state densities degrade device performance. Also, the devices that have a metal gate electrode tend to have a higher threshold voltage due to the barrier height between the metal and silicon. Higher threshold voltages are not desired, since CMOS devices that operate at supply voltages of less than 1 volt for 70 nm gate lengths are sought.

The gate electrode is formed by depositing a layer of amorphous silicon over the gate dielectric layer. The amorphous silicon layer is then doped using a suitable low-energy implant. The dopants are activated using conventional rapid thermal processing or other conventional methods for dopant activation. A metal layer is then formed over the amorphous silicon layer as the contact for the gate electrode.

The gate is then patterned by removing those portions of the layers that do not overlie the trench. This step is performed using conventional lithographic techniques. After the gate is formed, the device is completed using conventional techniques for semiconductor device fabrication.

### BRIEF DESCRIPTION OF THE DRAWINGS

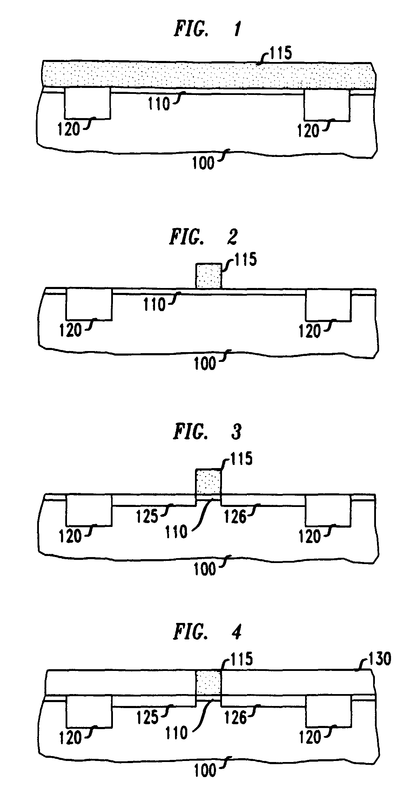

FIGS. 1 through 7 are a cross-sectional view a semiconductor substrate for explaining the device fabrication process according to a first embodiment of the present invention.

### DETAILED DESCRIPTION

In an exemplary embodiment of the present invention, shallow trench isolation is first performed on a semiconductor substrate. The purpose of shallow trench isolation is to electrically isolate a first device active region formed on the substrate from a second device active region. Shallow trench isolation processes are well known to one skilled in the art, and the conditions for shallow trench isolation will not be discussed in detail herein. Furthermore, although shallow trench isolation is used to electrically isolate two device active regions on a single substrate from each other, only one device active region is present in the FIGS. used to illustrate the process sequence.

With reference to FIG. 1, shallow trench isolation regions 120 are formed in the silicon substrate 100. The substrate is then doped. For example, in CMOS device fabrication, tub and punch-through implants are performed after the shallow trench isolation defines the active areas on the substrate. Typically, an anneal is required to activate the dopants. However, in certain embodiments, an anneal is not required to activate the dopants. Annealing conditions for activating dopants at this stage in the process sequence are well known to one skilled in the art. Annealing temperatures of about 800°C to about 1050°C are typically used.

A thin layer of silicon dioxide 110 is then formed on a silicon substrate 100. This thin layer of oxide is typically referred to as a pad oxide. The thickness of the pad oxide depends upon the dimensions of the device being formed and is largely a matter of design choice. For purposes of illustration, a device having a gate length of less than 70 nm, a pad oxide with a thickness of 6 nm is contemplated as suitable.

A layer of sacrificial gate material 115, such as silicon nitride, is formed over the pad oxide layer 110. Again, the thickness of the sacrificial gate material depends upon the dimensions of the device being formed. In the illustrated embodiment wherein the pad oxide 110 is 6 nm thick, a sacrificial gate thickness of 100 nm is contemplated as suitable. Since the sacrificial gate 115 serves as an etch stop for chemical mechanical polishing in subsequent processing, its thickness is selected so that it can perform this function. Based on current process requirements for chemical mechanical polishing, thicknesses of greater than about 60 nm are required. Thicknesses of greater than 100 nm may be required. The underlying pad oxide 110 thickness is selected to buffer the stress on the substrate from the sacrificial gate material. The ratio of the sacrificial gate material 115 thickness to the pad oxide thickness is less than about 20 to accomplish this objective.

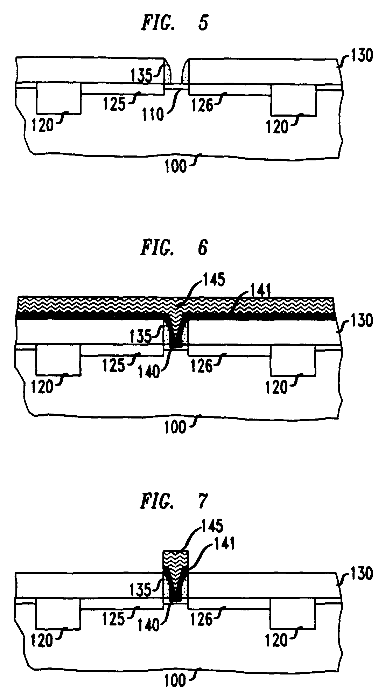

Referring to FIG. 2, the dielectric layer 115 is patterned using standard lithographic techniques for device processing. A layer of energy sensitive resist material (not shown) is formed on the structure depicted in FIG. 1. A pattern (not shown) is formed in the layer of energy sensitive material using conventional lithographic techniques. The pattern is used as an etch mask. The portion of layer 115 that is exposed through the mask is subsequently etched away. The etch is selective for the silicon nitride material, and the etch stops either on the silicon dioxide layer 110 or the substrate 100. The mask (not shown) is removed and the portion of the dielectric layer 115 that remains is illustrated in FIG. 2. The width of the portion of dielectric layer 115 that remains between the insulating regions 120 is selected to define the maximum gate length of the device. The width defines the maximum gate length because the width defines the space in which both the gate and dielectric spacers (135 in FIG. 5) are formed. Because of the formation of the gate in the space defined by the remaining portion of dielectric layer 115, the gate length can be no longer than the width of the remaining portion of dielectric layer 115.

Referring to FIG. 3, the structure in FIG. 2 is subjected to ion implantation to form the source 125 and drain 126 of the device. Conventional ion implantation is used. The energy of the implant and the concentration of the dopants in the source 125 and drain 126 regions is largely a matter of design choice. The structure depicted in FIG. 3 is then annealed to activate the dopants in the substrate 100. The exposed portion of silicon oxide layer 110 is then removed and a layer of metal silicide (e.g. cobalt silicide) is formed (not shown) using a metal suicide process. The thickness of the metal suicide layer is a matter of design choice. The silicide lowers the contact resistance between the source 125 and the drain 126 and the contacts (not shown) therefor.

Referring to FIG. 4, a layer of trench dielectric material 130, such as an oxide deposited from a high density plasma (HDP) is formed over the structure depicted in FIG. 3. The trench dielectric layer is polished back using chemical mechanical polishing to obtain the structure depicted in FIG. 4.

The structure depicted in FIG. 4 is then subjected to a wet etch to remove the silicon nitride sacrificial gate 115. Etch expedients that selectively remove silicon nitride without significant etching of silicon dioxide are well known to one skilled in the art. One example of a suitable etch is phosphorous acid at 180°C. The etch rate of silicon nitride in such an etchant is about 5 nm/min to about 7 nm/min. The etch rate of silicon dioxide in the same such etchant is about zero.

Referring to FIG. 5, the nitride spacers, 135 are formed by depositing a blanket layer of silicon nitride and subjecting that silicon nitride layer to an anisotropic etch. In the present embodiment wherein the trench width is about 70 to about 130 nm, the as-deposited thickness of the silicon nitride layer is about 20 to about 50 nm. The thickness of the silicon nitride layer will determine the size of spacers, which, in turn, determines the final gate length

After the spacers 135 are formed, dopant is implanted into the substrate to form the channel of the device. This is referred to as the local channel implant. The spacers ensure that dopant is implanted only in the substrate region between the spacers. The implant energy and dose are a matter of design choice, and are selected to provide a device with the desired threshold characteristics. The dopant is an n-type dopant (e.g. phosphorus) for p-channel MOSFET devices. The dopant is a p-type dopant (e.g. boron) for n-channel MOSFET. A rapid thermal anneal (exemplary conditions of 950°C for 10 seconds) is performed to activate the dopant. This anneal is optionally used to activate the dopants in the source and drain as well.

Then, the exposed portion of the pad oxide layer 110 is removed. A gate dielectric, 140 is selectively formed on the portion of the substrate surface 100 that is exposed between the two spacers 135. Although conventional gate dielectric materials such as silicon dioxide are contemplated as suitable, high dielectric constant materials such as tantalum oxide, silicon oxynitride are also contemplated. For example, thin (e.g. less than about 5 nm thick) silicon dioxide layers can be grown by a standard thermal oxidation process. Alternate dielectric materials are deposited over the entire substrate surface using blanket deposition. For example, a thin film of tantalum oxide is deposited (e.g. deposited at 400°C and annealed at 650°C) on the substrate surface. The dielectric thickness is selected to ensure that the trench is not completely filled by the dielectric material. The objective is for the gate electrode to be in the trench.

A layer of polycrystalline silicon 141 is formed over the resulting structure. It is advantageous if the thickness of layer 141 is uniform, and therefore conformal with the underlying layer (for doping uniformity). In this regard, it is advantageous if the portion of the polycrystalline layer 141 formed in the window has a "V" configuration. For example, in an embodiment wherein the width of the trench is about 80 nm and the distance between the spacers 135 is about 35 nm, the polycrystalline layer 141 has a thickness of about 25 nm. The resulting structure is then subjected to an ultra low energy gate electrode implant to dope the polycrystalline layer and provide it with suitable conductivity. The structure is then annealed (e.g. 5 seconds at 950°C) to activate the dopant. The implant and anneal conditions are selected so that adverse polycrystalline depletion effects are avoided. Low energy implant conditions are well known to one skilled in the art. The particular dopant selected depends upon whether the device is an n-MOS or a p-MOS device.

A layer of metal 145 is then formed over the structure. One example of a suitable metal is tungsten. The thickness of the metal layer is selected to satisfy the sheet resistance requirement for sub-100 nm gates. A metal layer thickness of about 50 nm is contemplated as suitable. For some metal (e.g. tungsten) additional barrier layers (not shown), such as titanium and titanium nitride, are needed to prevent interaction between the metal and the polycrystalline silicon.

The structure illustrated in FIG. 6 is then patterned to define the device gate. Standard lithographic techniques are used to form and pattern a mask (not shown) over layer 145. The mask covers the portion of layer 145 that overlies the width of the window in which spacers 135 are formed. The portion of layer 145 not covered by the mask is removed using a conventional etch expedient such as plasma etching. The mask is then removed and the resulting structure is depicted in FIG. 7.

The device depicted in FIG. 7 is subjected to further processing to form an integrated circuit device. The device fabrication sequence described above is provided to illustrate the invention. Alternative materials and process sequences for fabricating the described device are contemplated. For example there are various places in the above-described sequence where the dopant implants (e.g. the tub implant, the punch through implant and the channel implant) can occur. In the previously described sequence, the tub and punch through implants are done before the sacrificial gate is formed. Also, in the previous sequence, the channel implant is performed after the spacers are formed in the trench. This is advantageous because confining the channel implant in this manner improves the ability to control short channel effects.

In alternate embodiments, the tub and/or the punch-through implants are performed either: 1) after the sacrificial gate is removed but before the spacers are deposited; or 2) after the spacers are defined but before the final gate stack is deposited. In another alternate sequence, all three channel, punch-through, and isolation implants are performed before the sacrificial gate feature is defined lithographically. This provides a laterally uniform, gate-length-independent doping, which exhibits acceptably small threshold voltage variations with gate length in the gate length range of about 100 nm to 100 µm.

## Claims

1. A semiconductor device comprising:
a semiconductor substrate in which a source, drain and channel are formed;
a gate formed on a gate dielectric layer formed on the semiconductor substrate;
spacers adjacent to the gate wherein the gate and spacers are formed in a trench formed in a layer of dielectric material formed on the substrate surface.

2. The semiconductor device of claim 1 wherein the distance between the spacers defines a device gate length.

3. The semiconductor device of claim 2 wherein the distance between the spacers is less than 50 nm.

4. A process for device fabrication comprising:
forming a sacrificial gate over an active region of a semiconductor substrate wherein the width of the sacrificial gate is selected to define the distance between a source region and a drain region in the semiconductor substrate;
forming a trench dielectric layer adjacent to the sacrificial gate;
removing the sacrificial gate, thereby defining a trench in the trench dielectric layer;
forming spacers in the trench; and
forming a device gate in which at least a portion of the gate is formed between the spacers.

5. The process of claim 4 wherein a first layer of dielectric material is formed on the semiconductor substrate before the sacrificial gate is formed thereon and wherein the sacrificial gate is formed on the active region of the substrate.

6. The process of claim 5 wherein the active region in the semiconductor substrate is defined by shallow trench isolation.

7. The process of claim 6 further comprising implanting dopant into the semiconductor substrate after the sacrificial gate is formed thereover, wherein the implant conditions are selected to define a source and a drain region in the semiconductor substrate.

8. The process of claim 6 further comprising implanting dopant into the semiconductor substrate after the spacers are formed thereover.

9. The process of claim 6 wherein the gate is formed by:
forming a gate dielectric layer between the spacers;
forming a gate electrode over the gate dielectric layer;
forming a layer of metal over the gate electrode; and
patterning the layer of dielectric material with the layer of metal thereover to form the gate.

10. The process of claim 4 wherein the trench dielectric layer is formed by:
depositing a layer of trench dielectric material over the substrate with the sacrificial gate thereon;
polishing the layer of trench dielectric material; and
stopping the polishing of the trench dielectric material after the sacrificial gate is exposed therethrough.

11. The process of claim 10 wherein the trench dielectric layer is a layer of silicon dioxide and the sacrificial gate is silicon nitride.

12. The process of claim 11 wherein the trench dielectric layer is deposited from a high density plasma.

13. The process of claim 11 wherein the sacrificial gate is removed using a wet etch.

14. The process of claim 11 wherein the spacers are silicon nitride.

15. The process of claim 11 wherein the spacers are formed by:
depositing a layer of silicon nitride on the surface of the semiconductor substrate with the trench dielectric layer thereon after the trench is formed in the trench dielectric layer; and
anisotropically etching the silicon nitride layer to form the spacers.

16. The process of claim 15 further comprising a local channel implant after the spacers are formed.

17. The process of claim 15 further comprising a local channel implant after the trench is formed.

18. The process of claim 15 further comprising removing the oxide from a portion of the semiconductor substrate surface between the spacers.

19. The process of claim 9 wherein the gate dielectric layer is selected from the group consisting of silicon dioxide, silicon oxynitride and tantalum oxide.

20. The process of claim 9 wherein the gate electrode is doped polycrystalline silicon.
